Europäisches Patentamt

European Patent Office

Office européen des brevets

(11) Veröffentlichungsnummer: **0 231 786 B1**

## EUROPÄISCHE PATENTSCHRIFT

(45) Veröffentlichungstag der Patentschrift: **08.07.92**

(51) Int. Cl.⁵: **G01D 3/04**, G01R 29/00

(21) Anmeldenummer: **87100506.2**

(22) Anmeldetag: **16.01.87**

(54) Verfahren zur Elimination von Störungen eines Messsignals.

(30) Priorität: **06.02.86 DE 3603673**

(43) Veröffentlichungstag der Anmeldung:
**12.08.87 Patentblatt 87/33**

(45) Bekanntmachung des Hinweises auf die
Patenterteilung:
**08.07.92 Patentblatt 92/28**

(84) Benannte Vertragsstaaten:
**CH DE FR GB LI SE**

(56) Entgegenhaltungen:
**DE-A- 3 242 771**
**DE-A- 3 401 535**

**Handbook of Measurement Science Vol. 1**
**Theoretical Fundamentals, Ed.**
**P.H.Sydenham, Wiley & Sons 1982, pages**
**256-257, Abschnitt 6.3.5**

(73) Patentinhaber: **GESELLSCHAFT FÜR**
**STRAHLEN- UND UMWELTFORSCHUNG**
**M.B.H.**
**Ingolstädter Landstrasse 1**
**W-8042 Neuherberg(DE)**

(72) Erfinder: **Ruth, Bernhard**
**Ismaninger Strasse 38**
**W-8046 Garching(DE)**

## Beschreibung

Die Erfindung betrifft ein Verfahren zur Elimination von Störungen eines Meßsignals, nach dem Oberbegriff des Patentanspruches 1.

Analoge Meßsignale sind mit Störungen sehr unterschiedlicher Ursachen behaftet. Systematische Fehler verändern einen Meßwert einseitig und sind daher schwer zu erkennen und abzuschätzen.

Statistische Störungen (Rauschen) können durch eine zeitliche Integration vermindert oder vollständig eliminiert werden. Allerdings muß dabei vorausgesetzt werden, daß die Meßgröße in Zeitintervallen, die der Größe der benutzten Zeitkonstanten entsprechen, unverändert bleibt. Im Allgemeinen begrenzt damit die zeitliche Konstanz der Meßgröße den Wert der Zeitkonstanten und damit die Meßgenauigkeit. Die Reduktion statistischer Fehler durch zeitliche Integration ist darauf zurückzuführen, daß man praktisch im Spektrum des Meßsignals eine Grenzfrequenz einführt. Die Anteile oberhalb der Grenzfrequenz werden als Störung angesehen und durch einen Frequenzfilter eliminiert. Die Trennung zwischen Störung und eigentlichem Meßwert erfolgt damit aufgrund der spektralen Eigenschaft.

Eine Trennung mit Hilfe eines Frequenzfilters setzt aber voraus, daß die Störungen zu Änderungen des Meßsignals führen, die in Häufigkeit und Amplitude symmetrisch um den wahren Meßwert verteilt sind.

Das aber ist häufig nicht der Fall. Tritt z. B. ein stark verrauschtes Meßsignal, das daher mit einem Tiefpaß gefiltert werden muß und das einen relativ langsam veränderlichen Mittelwert hat, zusammen mit vergleichsweise kurzen Störungen auf, die das aktuelle Meßsignal ausschließlich beträchtlich vergrößern (bzw. verkleinern), so wird der Meßwert, der durch eine zeitliche Integration gewonnen wird, systematisch vergrößert (verkleinert). Eine zeitliche Integration führt daher in diesem Fall zu einem zusätzlichen systematischen Fehler, der aufgrund der Integration bzw. Tiefpaß-Filterung nicht mehr erkannt werden kann.

Äquivalente Störungen treten auch bei einem digitalen Signal auf, das z. B. durch eine Folge von Einheitsimpulsen gebildet wird und bei dem das Meßsignal durch die Zählrate der Einheitsimpulse gegeben ist. Ein Beispiel ist die Messung einer Lichtintensität durch einen Photomultiplier, der als Photonenzähler betrieben wird. Die auftretende Zählrate der Photonenimpulse ist proportional zur Lichtintensität. Besonders bei dem Bestimmen niedriger Intensitäten, die nur mit großen Meßintervall-Längen möglich sind, treten eine ganze Reihe von Störungen auf. Eine Art der Störungen ist dadurch gekennzeichnet, daß in einem relativ kleinen Zeitintervall zusätzliche Einheitsimpulse erzeugt werden und damit die Zählrate systematisch erhöhen. Dadurch wird natürlich der Meßwert der zu messenden Lichtintensität verfälscht. Die Ursache für solche sogenannten "bursts" sind durch elektromagnetische Störungen, kosmische Strahlung und Radioaktivität der Umgebung (speziell K-40 im Glas des Photomultipliers) gegeben.

Bei Messungen geringer Zählraten ist man daher darauf angewiesen, neben dem Meß-Photomultiplier einen gleichartigen zweiten Kontroll-Photomultiplier mit Photonenzählelektronik zu betreiben, auf den aber kein Licht fällt. Ein Auftreten eines bursts in dem Kontroll-Photomultiplier zeigt eine Störung an. Die Weiterverarbeitung der Impulse des Meß-Photomultipliers wird dann unterbrochen.

Gerade wenn die bursts durch kosmische Strahlen hervorgerufen werden, tritt die Schwierigkeit auf, daß der Kontroll-Photomultiplier eigentlich am selben Ort wie der Meß-Photomultiplier sein müßte. Man behilft sich dadurch, daß man den eigentlichen Meß-Photomultiplier mit mehreren Kontroll-Photomultipliern umgibt und dann beim Auftreten von Koinzidenzen der Kontroll-Photomultiplier die Weiterverarbeitung der Impulse des Meß-Photomultipliers unterbricht. Das Verfahren ist entsprechend sehr aufwendig.

Eine weitere Möglichkeit, den Einfluß der "bursts" zu reduzieren, besteht darin, die Bereitschaft des Zählers nach dem Registrieren eines Impulses für ein bestimmtes Zeitintervall zu unterbinden (verlängerte Totzeit). Dadurch würden kurz aufeinanderfolgende Impulse nicht registriert. Da die Dauer des "bursts" aber mehrere Größenordnungen über dem mittleren zeitlichen Abstand von zwei aufeinanderfolgenden Photonenimpulsen liegen kann, würde entweder die Totzeit zu lang oder aber es würden nach Ablaufen der Totzeit wiederholt Störimpulse registriert, die den Meßwert ebenfalls verfälschen.

Auch bei analogen Signalen können ebenfalls Störungen in der Form auftreten, daß in relativ kurzen Zeitintervallen vergleichsweise hohe Werte auftreten.

Ein Meßsignal dieser Form tritt etwa bei Gerät auf, das Gegenstand früherer Patentanmeldungen ist (DE-OS 32 42 771 und DE-OS 34 01 535). Dabei wird durch ein laser-optisches Verfahren die Durchblutung in der Haut gemessen. Da aber der größte Teil des Laserlichts an der nicht-durchbluteten Epidermis gestreut wird, und nicht in die Tiefe der durchbluteten Schichten vordringt, sind zwei Signale überlagert:

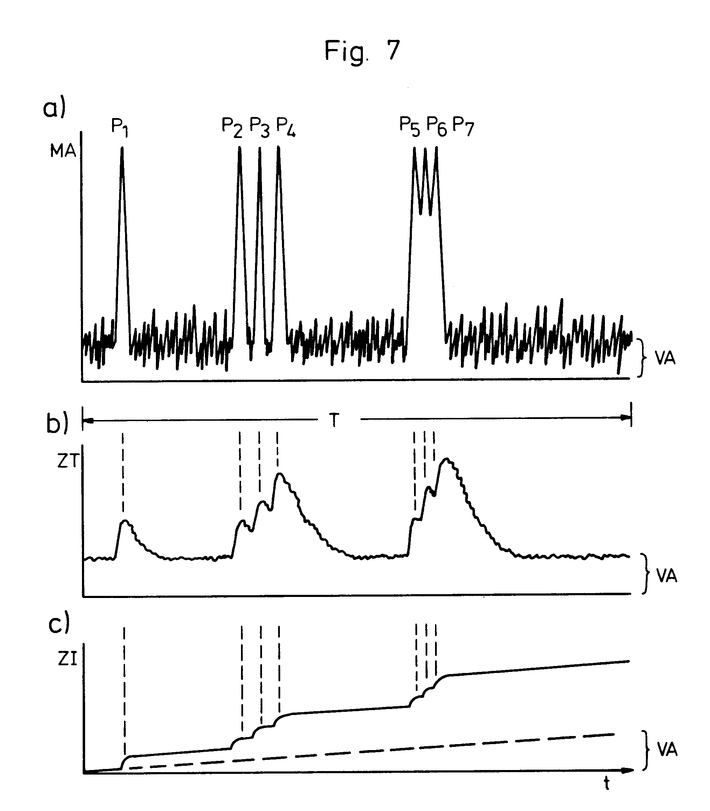

die Bewegung des Blutes und die der Epidermis. Ursprünglich ist das Signal von der Epidermis-Bewegung dominierend, durch verschiedene Vorkehrungen läßt sich dieser Einfluß verringern, aber nicht ganz unterdrücken. Ein solches Signal ist in Fig. 7a dargestellt.

Die Durchblutung in der Haut (Wert VA) ändert sich nur langsam, so daß sie im Rahmen dieser Betrachtung als konstant angesehen werden kann. Das Rauschen, das diesem Durchblutungswert überlagert ist, wird hauptsächlich durch die Speckle-Struktur, die der Messung zugrundeliegt, aber u. a. auch durch Rauschen von Laser und Elektronik, verursacht.

Die auftretenden Peaks $P_1$ bis $P_7$ werden dadurch verursacht, daß willkürlich oder unwillkürlich die Haut an der Meßstelle bewegt wird. Es sind zum Teil kurzdauernde Zuckungen. Insbesondere bei Patienten mit Durchblutungsstörungen der Extremitäten, bei denen Messungen der Hautdurchblutung durchgeführt werden, leiden unter sogenannten Ruheschmerzen, die sie durch bewußte und unbewußte Zuckungen mildern können.

Um das Rauschen zu reduzieren, kann das Signal MA durch einen Tiefpaß gefiltert werden. Die Zeitkonstante des Tiefpaß muß so bemessen sein, daß die auftretenden Frequenzen im Rauschen merklich gedämpft werden. Da das Spektrum der Störimpulse im selben Frequenzbereich liegt, entsteht am Ausgang des Tiefpaß ein abgewandeltes Signal ZT (siehe Fig. 7b). Das Rauschen ist sichtbar reduziert, aber die Störungen verursachen aufgrund ihrer Höhe einen raschen Anstieg dieses Signals mit einem langsamen Abklingen entsprechend der Zeitkonstanten. Wird die Zeitkonstante vergrößert, so fällt bei Eintreten der Störung zwar der Anstieg geringer aus, dafür ist die Zeitdauer bis zum Erreichen des Meßwert-Niveaus verlängert. In dem angeführten Beispiel wird während eines beträchtlichen Teils des Meßintervalls der Länge T ein überhöhter Wert angezeigt.

Eine andere Möglichkeit, das Rauschen zu reduzieren, ist die Integration von MA mit entsprechenden Zeitkonstanten während des Meßintervalls der Länge T. Die Störungen werden ebenfalls nicht eliminiert, sondern sind als Stufen in der Kurve (ZI) zu erkennen (siehe Fig. 7c). Die Fehler werden summiert, so daß am Ende des Meßintervalls in Vergleich zum eigentlichen Meßwert ein ebenfalls überhöhter Wert angezeigt wird. Die schräge Linie gibt den Verlauf von ZI ohne Störung an.

Die der Erfindung gestellte Aufgabe besteht darin, das e. g. Verfahren derart auszugestalten, daß bei der Bestimmung eines Meßwertes mittels Meßsignalen, die von statistischen und systematischen Fehlern behaftet sind, Fehler eliminiert werden sollen, die durch Ereignisse auftreten, die nicht meßwertspezifisch sind.

Die Lösung en sind in den kennzeichnenden Merkmalen der Ansprüche 1 und 5 beschrieben.

Die übrigen Ansprüche geben vorteilhafte Weiterbildungen des erfindungsgemäßen Verfahrens nach dem Anspruch 1, einer Schaltungsanordnung derselben sowie Verwendungsbeispiele an.

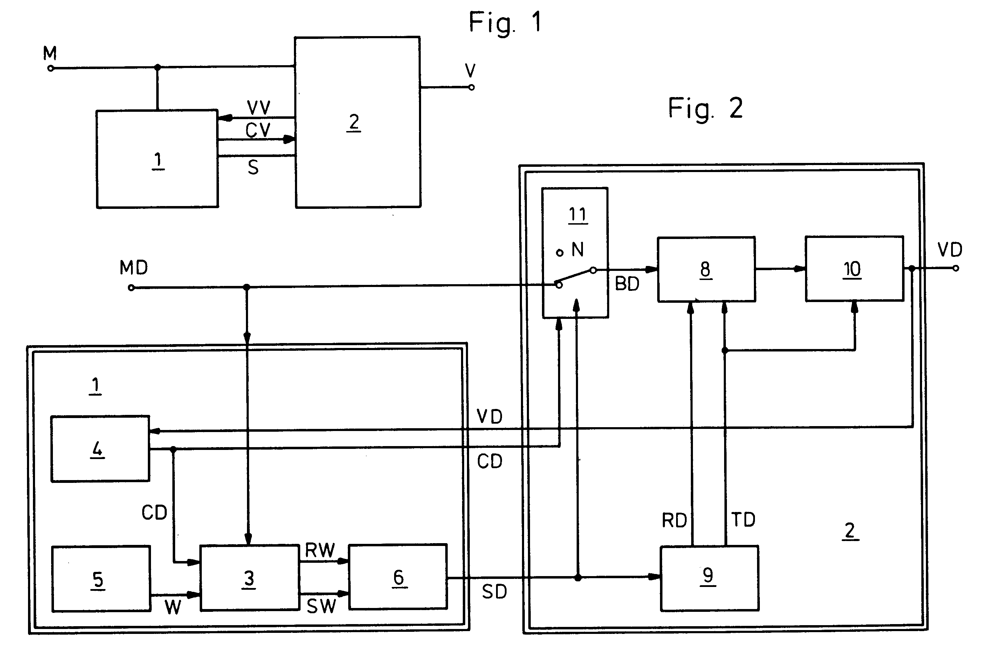

Die Erfindung wird im folgenden anhand zweier Ausführungsbeispiele mittels der Fig. 1 - 6 näher dargestellt.

Das erfindungsgemäße Verfahren nutzt andere Eigenschaften des zeitlichen Verhaltens einer Störung aus, um sie zu erkennen und bei der Meßwert-Bildung zu berücksichtigen. In Fig. 1 ist der prinzipielle Aufbau einer Schaltungsanordnung zur Durchführung des Verfahrens dargestellt, das für digitale und analoge Verfahren anwendbar ist.

Der Vorteil des Verfahrens besteht darin, daß in einem verrauschten Meßsignal, das für eine Auswertung unbedingt geglättet werden muß, und in dem zusätzliche Störungen vorhanden sind, die bei der Meßwertbildung zu einer systematischen einseitigen Verfälschung des Meßsignals führen, diese Störungen erkannt und bei der Meßwertbildung so berücksichtigt werden, daß bei gleichzeitiger Unterdrückung des Rauschens keine systematische Verfälschung des Meßwertes entsteht.

Eine entsprechende Schaltung ist mit einfachen elektronischen Komponenten zu realisieren und in einem weiten Frequenzbereich einsetzbar.

Das Meßsignal M (digital oder analog) wird in einer "Kontroll-Einheit" 1 aufgrund von Erfahrungswerten daraufhin untersucht, ob eine Störung vorliegt oder nicht.

Die Kriterien für eine solche Entscheidung können entweder vollständig von außen vorgegeben werden, oder von der Einheit selbst anhand von externen Vorgaben aus dem bisherigen Verlauf des Meßsignals ermittelt werden oder auch mit Hilfe eines Signals VV aus der Einheit 2 festgelegt werden. Bei Vorliegen einer Störung erzeugt die Einheit 1 ein logisches Signal S, das von den folgenden Einheiten weiterverarbeitet wird.

Die Umsetzung des Meßsignals M in einen Meßwert V erfolgt in der Einheit "Meßwert-Bildung" 2. Es handelt sich dabei um eine Anordnung, die entsprechend den Anforderungen aus dem vorliegenden Meßsignal M einen Meßwert V bilden kann (VD digital oder VA analog), aber diesen Prozeß aufgrund eines logischen Signals S unterbrechen und nach Ende der Unterbrechung wieder fortsetzen kann, ohne daß durch die Dauer des Unterbrechens ein zusätzlicher Fehler auftritt. Im allgemeinen besteht die Einheit aus einer Anordnung zur Mittelwertbildung und aus einer zweiten zur Zeitkontrolle. Beide Anordnungen müssen aufgrund eines logischen Signals ihre Funktion reversibel unterbrechen können. Ggf. benötigt die Einheit 2 Informationen über bestimmte Parmeter von Einheit 1, wie durch das Signal CV in Fig. 1 angegeben ist.

Im folgenden wird eine elektronische Schaltung beschrieben, die entsprechend Fig. 1 die Störungen (bursts) erkennt, ohne daß dabei ein zweiter Photomultiplier notwendig ist. Die Schaltung und die Signalverläufe bzw. Zählerstände selbst sind in Fig. 2 bzw. 3a - g, dargestellt.

Zum Feststellen der Störung dient die Kontroll-Einheit 1. Dazu wird die Zeitdifferenz zwischen zwei aufeinanderfolgenden Photonenimpulsen im Meßsignal MD bestimmt und eine Störung dadurch erkannt, daß die Zeitdifferenz zwischen zwei aufeinanderfolgenden Photonenimpulsen in MD ein festgelegtes Minimum unterschreiten. Dieses Minimum ist die Schwelle CD.

Impulsgenerator 5:

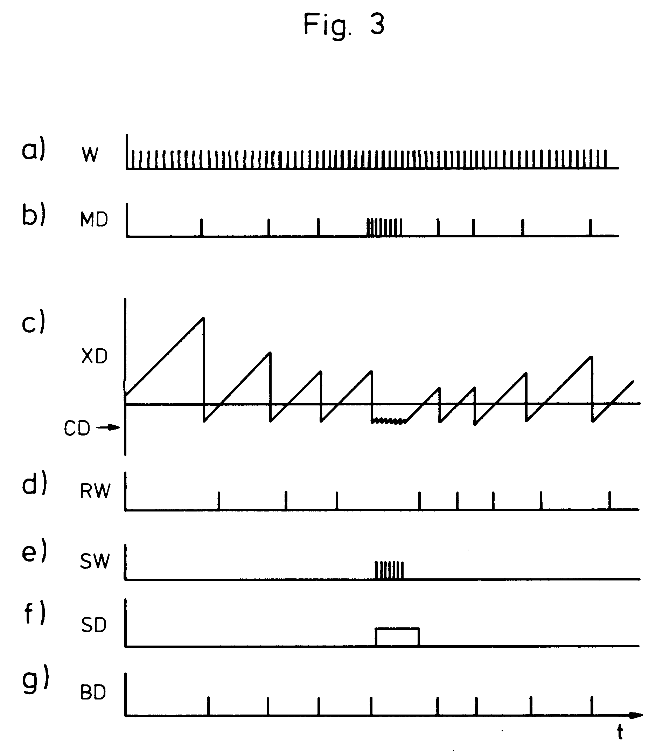

Seine Aufgabe: Erzeugung von Impulsen W (Fig. 3a) mit einer einstellbaren Zählrate, die um mindestens eine, besser aber zwei Größenordnungen größer ist als die des Meßsignals MD (Fig. 3b).

Der Impulsgenerator erzeugt praktisch die Zeittakte, mit denen die Zeitdifferenz zwischen den Photonenimpulsen gemessen werden.

Einheit 3: "Zähler und Signalgenerator"

Der Zähler zählt die Impulse W (Fig. 3a) vom Impulsgenerator 5 beginnend mit der negativen Zahl CD (siehe Fig. 3c), die in Einheit 4 gespeichert ist. Wird der Zählerinhalt XD (Fig. 3c) positiv, dann gibt Einheit 3 einen logischen Impuls RW (Fig. 3d) an Einheit 6 ab. Bei Eintreffen eines Impulses MD wird der Zählvorgang beendet. Ist der Zählerinhalt negativ, wird ein logischer Impuls SW (Fig. 3e) an die Einheit 6 abgegeben. Ist der Zählerinhalt positiv, wird kein Impuls erzeugt. Anschließend wird die Zahl CD von Einheit 4 in den Zähler geladen und die Zählung der Impulse W beginnt von Neuem.

Speichereinheit 6 (Flip-Flop):

Aufgabe: Bei Eintreffen des Impulses RW wird der Ausgang SD = 0 gesetzt. Es ist keine Störung erkannt worden. Weitere Impulse RW ändern nichts. Dieser Zustand bleibt so lange bestehen, bis ein logischer Impuls SW den Ausgang SD = 1 setzt, es liegt also eine Störung vor. Weitere Impulse SW ändern nichts an SD (Fig. 3f).

Generator 4 zur Erzeugung der Vergleichszahl CD:

Aufgabe: Die Vergleichszahl CD (Fig. 3c) ist die Zeitdifferenz gemessen in Einheiten der Impulse W des Impulsgenerators die mit der Zeitdifferenz zwischen zwei Impulsen des Meßsignals MD verglichen werden soll. Kommen die Impulse schneller als durch CD angegeben, wird das als Störung angesehen.

Bei konstanter Zählrate des Meßsignals MD kann CD nach einem Erfahrungswert eingestellt werden. Bei einer zeitabhängigen Zählrate aber muß CD dieser Zählrate angepaßt werden. Das kann z. B. dadurch geschehen, daß die bereinigten Zählraten (Meßwert VD) aus dem Speicher 10 in Einheit 4 registriert werden und aus den letzten n Werten VC (n = 1 ...) (n einstellbar) der mittlere zeitliche Abstand der Impulse des Meßsignals bestimmt wird. CD ist dann ein einstellbares Vielfaches dieses mittleren zeitlichen Abstandes.

VD entspricht in diesem Fall der Rückmeldung VV aus Fig. 1.

Die Einheit 2 bildet den Meßwert VD durch Summieren aller Impulse MD, bei denen keine Störung SD vorliegt.

Einheit 8: Zähler

Die Einheit zählt die Impulse BD, für die im störungslosen Fall BD = MD gilt. Bei Vorliegen des logischen Signals TD wird der Zählvorgang beendet, damit ein ungestörter Transfer des Zählerinhalts nach Einheit 10 (Speicher) erfolgen kann. Das logische Signal RD bewirkt das Nullsetzen des Zählers.

Einheit 10: Speicher

Die Einheit 10 übernimmt den Zählerinhalt von Zähler 8 bei Vorliegen von Signal TD und stellt ihn während des folgenden Meßintervalls als Ausgangssignal VD zur Anzeige oder Weiterverarbeitung zur Verfügung.

Uhr 9:

Die Uhr 9 hat eine Einstellmöglichkeit der Meßintervall-Länge. Bei abgelaufenem Meßintervall erzeugt sie die Steuersignale TD und RD mit einem zeitlichen Verlauf, der den korrekten Datentransfer von Zähler 8 zum Speicher 10 gewährleistet.

Liegt das Signal SD = 1 vor, so wird der Zeitablauf unterbrochen und bei SD = 0 wieder aufgenommen. Ist es von der gestellten Aufgabe notwendig, daß zwischen dem Beginn aufeinanderfolgender Meßintervalle eine konstante Zeitdifferenz liegt, so muß die Uhr die Summe der Störzeiten registrieren. Nach Ablauf des festgesetzten Zeitintervalls muß dann dieser Wert bei der eigentlichen Meßwertbildung in geeigneter Weise berücksichtigt werden.

Schalter 11:

Aufgabe: In der einfachsten Ausführung verbindet der Schalter MD mit dem Eingang des Zählers 8 (BD = MD). Bei Vorliegen vom Signal SD wird

der Eingang von Zähler 8 auf Masse gelegt (BD = 0). Das Ausgangssignal BD ist in Fig. 3g dargestellt, die Störimpulse sind aussortiert. Bei niedrigen Zählraten und häufig auftretenden Störungen, ist eine aufwendigere Lösung notwendig. Ein Impuls MD wird so lange verzögert, bis die Entscheidung gefallen ist, ob SD = 1 gilt oder nicht. Erst dann wird er zum eigentlichen Schalter weitergeleitet und von dort dann zum Zähler oder nicht (im Fall SD = 1).

Zu diesem Zweck benötigt der Schalter 11 die Information über die minimale Zeitdifferenz CD, die maßgebend für die Dauer der Impulsverzögerung ist. Das Signal CD entspricht also dem Signal CV in Fig. 1.

Der Vorteil des Verfahrens kommt in diesem Anwendungsbeispiel insbesondere bei Messungen sehr geringer Lichtintensitäten zum Tragen. Es unterdrückt den Einfluß von bursts, die sehr viel länger dauern können als der mittlere Abstand von zwei aufeinanderfolgenden Photonenimpulsen, ohne daß dabei die Totzeit für das Registrieren der Photonenimpulse verlängert sein müßte.

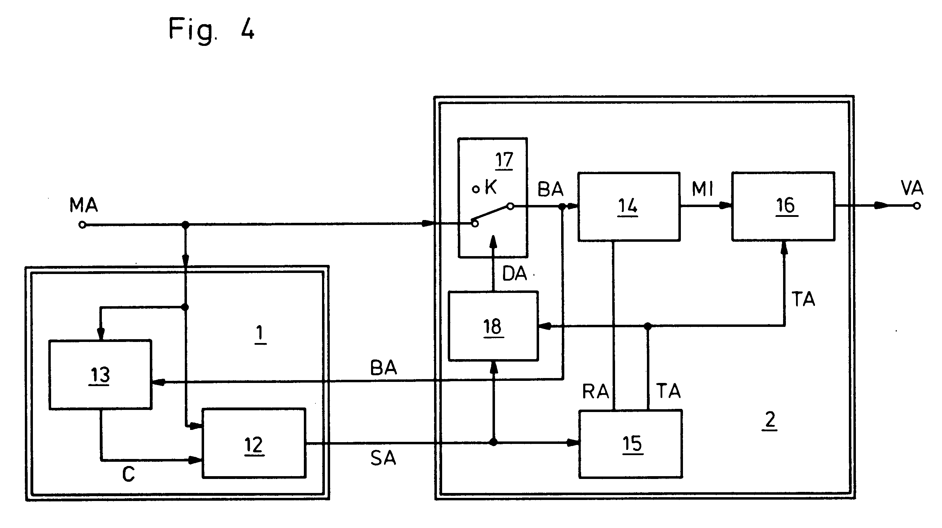

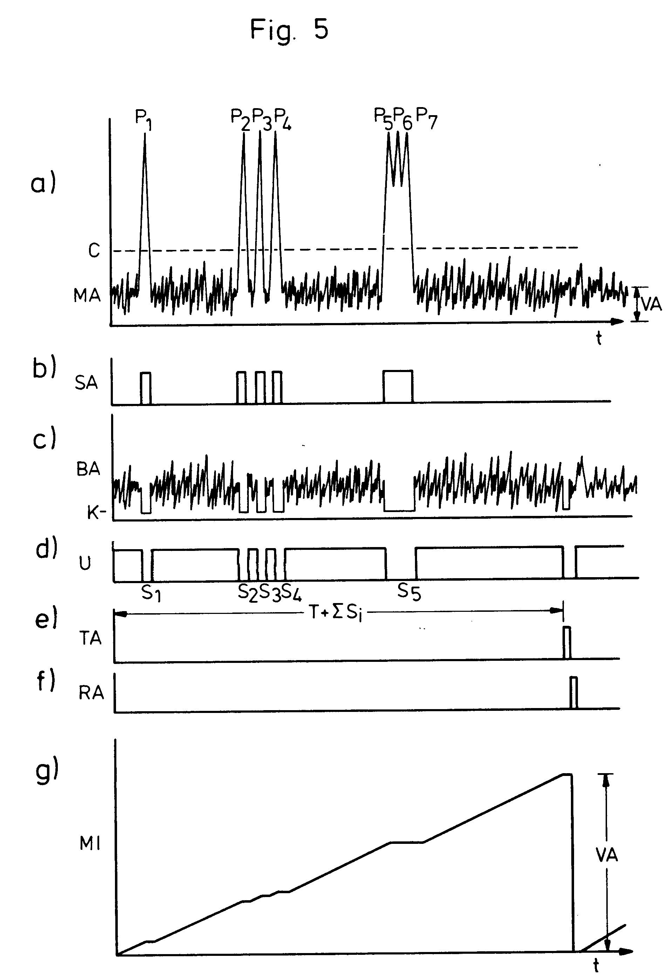

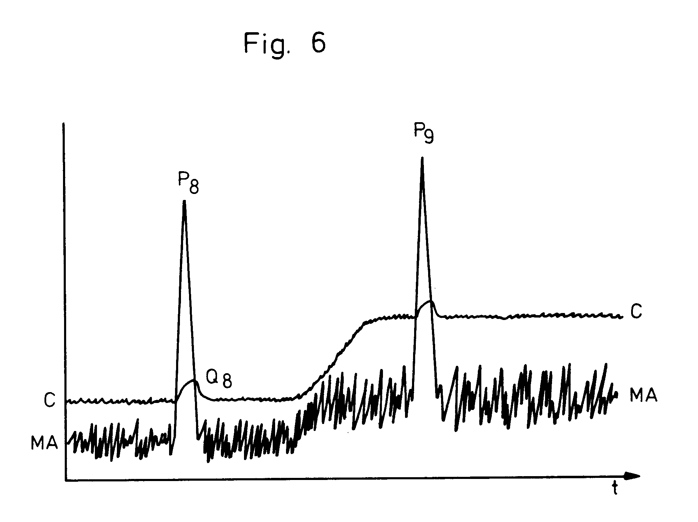

Bei analogen Signalen erfolgt das Erkennen von Störungen und die Meßwertbildung entsprechend der Schaltungsanordnung von Fig. 4 und den Signalverlaufen von Fig. 5a - g und Fig. 6.

Das analoge Signal MA hat den Verlauf entsprechend Fig. 5a, die Störungen $P_1$ - $P_7$ sollen erkannt werden und dürfen nicht zur Verfälschung des Meßwertes beitragen.

Das wird durch einen Vergleich des aktuellen Signals MA mit einer Schwelle C (Fig. 5a) möglich.

Komparator und Signalgenerator 12:

Die Einheit vergleicht die Signale MA und C, erzeugt MA> C das logische Signal SA = 1 (Fig. 5b) und zeigt eine Störung an. Bei MA ≤ C gilt SA = 0, es liegt keine Störung vor.

Der Wert von SA = 1 kann auch optisch oder akustisch angezeigt werden, um ggf. geeignete Maßnahmen gegen die Störungen einleiten zu können.

Signalgenerator 13 für die Erzeugung der Größe C (Schwelle):

Aufgabe: Im Fall, daß sich der Meßwert VA (Fig. 5a) nur geringfügig ändert, kann Einheit 13 aus einem Potentiometer bestehen, an dem das Signal C fest aufgrund der Erfahrung eingestellt werden kann. Dieser Fall ist in Fig. 5a dargestellt. Wenn sich aber VA ändert, und zwar mit Zeitkonstanten, die groß im Vergleich zu den Zeitkonstanten sind, mit denen die Störungen $P_1$...$P_7$ auftreten, dann muß das bei der Erzeugung von C berücksichtigt werden. In diesem Fall wird das Signal C aus dem Meßsignal MA durch eine Filterung mit einen Tiefpaß mit der Zeitkonstanten $\tau$ und anschließende Verstärkung erzeugt.

Das Verhalten von MA und C ist in diesem Fall in einem Beispiel in Fig. 6 erläutert bzw. dargestellt. Wenn der Meßwert VA konstant bleibt (praktisch der Mittelwert ohne die Störungen) ist auch C konstant mit einer kleinen statistischen Störamplitude. Die Verstärkung des Tiefpaß-gefilterten Signals legt fest, wie hoch C im Verhältnis zu VA ist. Bei Auftreten einer Störung in Form des Peaks $P_8$ entsteht auch ein kleinerer Peak $Q_8$ im Signal C. Das stört aber nicht die Funktion des Komparators 12, so daß die weitere Verarbeitung unverändert bleibt.

Steigt nun das Meßsignal MA an, so folgt die Größe C mit einer gewissen zeitlichen Verzögerung, die durch $\tau$ bestimmt wird. Die Zeitkonstante $\tau$ muß daher so eingestellt sein, daß einerseits das statistische Rauschen in MA merklich reduziert wird, andererseits die zeitliche Verzögerung zwischen den Signalen MA und C nicht zu groß wird.

Tritt nun auf dem erhöhten Nieveau eine Störung $P_9$ auf, so kann sie wie bisher erkannt werden. Bei einem unveränderten Wert C würden fälschlicherweise ständig Störungen angezeigt, da nun MA dieselbe Größe wie die usprüngliche Schwelle C hätte.

Das Signal C kann auch erzeugt werden, indem das entstörte Signal BA, das durch den Schalter 17 erzeugt wird, oder der Meßwert VA zugrundegelegt wird. In Fig. 4 ist die Übertragung des Signals BA an die Einheit 13 eingetragen. Das hat im Vergleich zum Ausnutzen von VA den Vorteil, daß die Schwelle C schneller auf Veränderungen des Meßsignals reagieren kann. Das in Einheit 1 eingespeiste Signal BA entspricht dem Signal VV von Fig. 1.

Die Einheit 2 in Fig. 4 bildet den Meßwert VA durch Integration des Meßsignals MA in den Zeitintervallen, in denen keine Störung SA = 1 angezeigt ist.

Schalter 17:

Aufgabe: Im Normalfield liegt der Schalter auf der Stellung, in der das Meßsignal MA an dem Integrator anliegt (BA = MA) (Fig. 5a und 5c). Bei Vorliegen des Signals DA (Störung oder Meßintervallende) wird auf K umgeschaltet. K ist eine Spannung (s. Fig. 5c), die so bemessen ist, daß der Ausgangswert MI vom Integrator 14 während der Zeit der Störungen SA oder des Meßwerttransfers (TA) konstant bleibt (s. Fig. 5g). Das Ausgangssignal BA ist in Fig. 5c dargestellt.

Uhr 15:

Die Uhr 15 hat eine Einstellmöglichkeit für die Meßzeit T. Der Zeitablauf wird während der Zeit der Störungen SA = 1, d. h. während $S_1$ bis $S_5$ - (Fig. 5d) unterbrochen. Nach Ablauf der Meßdauer T, d. h. nach der Zeit $T + \sum_i^{} S_i$ (Fig. 5e) werden der Zeitablauf unterbrochen sowie die Signale TA und RA in einem zeitlichen Verlauf erzeugt, die den korrekten Transfer von Integrator 14 zum Speicher 16 gewährleistet (Fig. 5e, f). Dann wird die Uhr von 0 beginnend in Gang gesetzt. Die Zeit, während der die Uhr läuft, ist als U = 1 in Fig. 5d angegeben.

Integrator 14:

Die Einheit integriert das Signal BA mit einer Zeitkonstanten, die groß ist im Vergleich zu den in BA auftretenden Fluktuationen. Das Ausgangssignal MI ist in Fig. 5g dargestellt. Bei Vorliegen von RA wird der Integrator auf Null gesetzt.

Speicher 16 (Sample & Hold):

Bei Vorliegen des Signals TA registriert Einheit 16 das aktuelle Signal MI, gibt es an den Ausgang als Signal VA weiter und hält es dort konstant, bis ein weiteres Signal TA anliegt (Fig. 5g). Damit bleibt VA während des folgenden Meßintervalls konstant und kann z. B. abgelesen oder weiterverarbeitet werden.

Oder-Stufe 18:

Aufgabe: Erzeugen des Signals DA, wenn entweder eine Störung vorliegt (SA = 1) oder ein Meßwerttransfer durchgeführt wird (TA = 1).

Der Vorteil dieses Verfahrens bei diesem Anwendungsbeispiel besteht darin, daß die Qualität der Rausch- und Störungsunterbrechung der Anwendung einer großen Zeitkonstante bei der Tiefpaßfilterung bzw. der Integration entspricht (Fig. 7b und c, Fig. 5g).

Im Gegensatz zu diesen gängigen Verfahren, wird aber ein von Störungen nicht verfälschter Meßwert erzeugt, der sich außerdem noch in einem gewissen Maß zeitlich ändern darf.

**Patentansprüche**

1. Eliminations verfahren von Störungen eines Meßsignals bei der Bestimmung der Durchblutung von Gewebe durch Erfassung eines Speckle-Musters, wobei das Meßsignal so verrauscht ist, daß eine Glättung bei der Meßwertbildung erforderlich ist und wobei solche Störungen auftreten, die zu einem systematischen Fehler bei der Meßwertbildung führen, dadurch gekennzeichnet, daß

a) das Meßsignal (MA) zur Bildung eines Meßwertes (VA) erfaßt wird,
b) mindestens eine Schwelle (C) vorgesehen ist, die vom Meßsignal (MA) über- bzw. unterschreitbar und dann als Störung erkennbar ist,
c) wobei die Schwelle (C) an die Änderung des Meßwertes (VA) durch Tiefpaßfilterung und Verstärkung des Meßwertes (MA) oder durch Berücksichtigung des Meßwertes (VA) aus davor liegenden Meßintervallen angepaßt werden kann,
d) die Zeit, während der das Meßsignal (MA) diese Schwelle (C) über- bzw. unterschreitet als Störzeit erfaßt wird, und
e) während dieser Zeit das aktuelle Meßsignal (MA) nicht zur Bildung des Meßwertes (VA) beiträgt.

2. Verfahren nach Anspruch 1, dadurch gekennzeichnet, daß zum Erkennen der Störung ein Vergleich zwischen dem aktuellen Meßsignal (MA) und charakteristischen Werten des Meßsignals (MA) in einem davor liegenden Zeitintervall durchgeführt wird.

3. Verfahren nach Anspruch 1 oder 2, dadurch gekennzeichnet, daß das Meßintervall um die Dauer der Störzeiten zur Gewinnung des Meßwertes (VA) verlängerbar ist.

4. Verfahren nach einem der Ansprüche 1 bis 3, dadurch gekennzeichnet, daß die Bildung des Meßwertes (VA) durch Integration des Meßsignals (MA) in einer Schaltungsanordnung (1, 2) erfolgt.

5. Verfahren nach dem Oberbegriff des Patentanspruchs 1, dadurch gekennzeichnet, daß
a) Meßsignale (MD) in eine Folge von Einheitsimpulsen umgewandelt werden,
b) eineZeitdifferenz (CD) vorgesehen ist, deren Unterschreitung durch zwei oder mehr Einheitsimpulse (MD) eine Störung anzeigt,
c) wobei diese Zeitdifferenz (CD) aus dem mittleren zeitlichen Abstand zwischen zwei Einheitsimpulsen in einem vergangenen Zeitintervall ermittelt wird und
d) der Meßwert (VD) durch Summierung aller Einheitsimpulse (MD) in einem vorgegebenen Zeitintervall, welche nicht als Störung erkannt werden, gebildet wird.

**Claims**

1. Process for eliminating disturbances in a measuring signal during the determination of the flow of blood through tissue by detecting a speckle pattern, the measuring signal being so full of noise that a smoothing is required during the formation of the measurement value, and wherein such disturbances occur which lead to a systematic error during formation of the measurement value, characterised in that

a) the measuring signal (MA) is detected for the formation of a measurement value (VA),

b) at least one threshold (c) is provided, which is exceedable or non-attainable by the measuring signal (MA) and is then recognisable as a disturbance,

c) the threshold (c) being adaptable to the change in the measurement value (VA) as a result of low-pass filtering and amplification of the measurement value (MA) or as a result of taking into consideration the measurement value (VA) arising from preceding measuring intervals,

d) the time, during which the measuring signal (MA) exceeds or does not reach this threshold (c), is detected as the disturbance time, and

e) during this time the actual measuring signal (MA) does not contribute towards the formation of the measurement value (VA).

2. Process according to claim 1, characterised in that, in order to detect the disturbance, a comparison is made between the actual measuring signal (MA) and characteristic values of the measuring signal (MA) in a preceding time interval.

3. Process according to claim 1 or 2, characterised in that the measuring interval is extendable by an amount corresponding to the duration of the disturbance times in order to obtain the measurement value (VA).

4. Process according to one of claims 1 to 3, characterised in that the formation of the measurement value (VA) is effected by integration of the measuring signal (MA) in a circuit arrangement (1, 2).

5. Process according to the preamble of claim 1, characterised in that

a) measuring signals (MD) are converted into a sequence of unit pulses,

b) a time difference (CD) is provided, its non-attainment by two or more unit pulses (MD) indicating a disturbance,

c) this time difference (CD) being determined from the average interval of time between two unit pulses in a previous time interval, and

d) the measurement value (VD) is formed by summing all of the unit pulses (MD) in a predetermined time interval, which are not recognised as a disturbance.

**Revendications**

1. Procédé pour éliminer des perturbations dans un signal de mesure, dans le cas de la détermination de la pénétration de tissus pour détection dans un échantillon graisseux, dans lequel le signal de mesure est perturbé par du bruit de telle sorte qu'il est nécessaire d'effectuer un lissage lors de la formation de la valeur de mesure et dans lequel il survient de telles perturbations qui conduisent à un défaut systématique lors de la formation de la valeur de mesure, procédé caractérisé en ce que :

a) le signal de mesure (MA) est détecté pour la formation d'une valeur de mesure (VA),

b) il est prévu au moins un seuil (C), qui peut être dépassé ou sous dépassé par le signal de mesure (MA) et peut être alors reconnue comme perturbation,

c) dans lequel le seuil (C) peut être adapté à la variation de la valeur de mesure (VA) par un filtrage par un filtre passe-bas et par amplification de la valeur de mesure (MA) ou par prise en considération de la valeur de mesure (VA) à partir des intervalles de mesure existant auparavant,

d) le temps, pendant lequel le signal de mesure (MA) dépasse ou sous dépasse ce seuil (C), est reconnu comme temps de perturbation et

e) pendant ce temps le signal réel de mesure (MA) ne contribue pas à la formation de la valeur de mesure (VA).

2. Procédé selon la revendication 1, caractérisé en ce que, pour détecter la perturbation on effectue une comparaison entre le signal de mesure réel (MA) et des valeurs caractéristiques du signal de mesure (MA) dans un intervalle existant auparavant.

3. Procédé selon la revendication 1 ou 2, caractérisé en ce que l'intervalle de temps peut être prolongé de la durée des temps de perturbation pour obtenir la valeur de mesure (VA).

4. Procédé selon l'une des revendications 1 à 3, caractérisé en ce que la formation de la valeur de mesure (VA) a lieu par intégration du signal de mesure (MA) dans un circuit (1, 2).

5. Procédé selon le préambule de la revendication 1, caractérisé en ce que :

a) des signaux de mesure (MD) sont convertis en une suite d'impulsions unitaires,

b) il est prévu une différence de temps (CD) dont le sous dépassement par deux impulsions unitaires (MD) ou plus indique une perturbation,

c) dans lequel cette différence de temps (D) est détectée à partir d'un intervalle de temps moyen entre deux impulsions unitaires dans un intervalle de temps passé et

d) la valeur de mesure (VD) est formé par la sommation de toutes les impulsions unitaires (MD) dans un intervalle de temps prédéfini, qui ne sont pas reconnues comme perturbation.

Fig. 1

Fig. 2

EP 0 231 786 B1

# Fig. 3

a)  W

b)  MD

c)  XD

CD →

d)  RW

e)  SW

f)  SD

g)  BD

t

Fig. 4

Fig. 5

Fig. 6

Fig. 7